(19) Europäisches Patentamt
European Patent Office
Office européen des brevets

(11) **EP 4 510 447 A1**

(12) **EUROPEAN PATENT APPLICATION**
published in accordance with Art. 153(4) EPC

(43) Date of publication:
**19.02.2025 Bulletin 2025/08**

(51) International Patent Classification (IPC):
***H03F 3/189*** *(2006.01)*

(21) Application number: **22941039.4**

(52) Cooperative Patent Classification (CPC):
**H03F 3/189**

(22) Date of filing: **09.05.2022**

(86) International application number:
**PCT/CN2022/091778**

(87) International publication number:
**WO 2023/216071 (16.11.2023 Gazette 2023/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **SUN, Yiping**
  **Shenzhen, Guangdong 518129 (CN)**
• **HE, Chuan**
  **Shenzhen, Guangdong 518129 (CN)**
• **SUN, Jie**
  **Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **POWER AMPLIFICATION CIRCUIT AND RADIO FREQUENCY SYSTEM**

(57) This application discloses a power amplifier circuit and a radio frequency system. The circuit includes a power amplifier unit and a broadband improvement unit. The power amplifier unit includes a signal input port, a signal output port, a power transistor, and a first inductor. The power transistor is configured to perform power amplification on radio frequency signals in a plurality of frequency bands. The broadband improvement unit adjusts a parallel resonance frequency of the power amplifier unit, to reduce envelope impedance of the power amplifier unit between a first target frequency and a second target frequency. The first target frequency is a maximum frequency difference between the plurality of frequency bands, and the second target frequency is a minimum frequency difference between the plurality of frequency bands. In this application, on the basis of not adding an output internal matching circuit, the envelope impedance between the first target frequency and the second target frequency is reduced through the added broadband improvement unit, so that a video bandwidth of the power amplifier circuit is increased and DPD linearity of a broadband signal is improved.

```
┌─────────────────────────────────────────┐
│   ┌─────────────────────────────────┐    │
│   │                                 │    │
│   │    Power amplifier unit 301     │    │
│   │                                 │    │
│   └─────────────────────────────────┘    │
│                                           │
│   ┌─────────────────────────────────┐    │
│   │                                 │    │
│   │  Broadband improvement unit 302 │    │
│   │                                 │    │
│   └─────────────────────────────────┘    │
│                                           │
│        Power amplifier circuit 300        │
└─────────────────────────────────────────┘
```

**FIG. 3**

**Description**

**TECHNICAL FIELD**

This application relates to the field of radio frequency amplification, and in particular, to a power amplifier circuit and a radio frequency system.

**BACKGROUND**

As a 5th generation mobile communication technology (5th generation mobile communication technology, 5G) is widely used, a signal bandwidth is continuously increasing. The shortage of spectrums and the effective utilization of base station resources also encourage more operators to share base station resources and the spectrums. In this way, a base station needs to support a larger signal bandwidth. For example, a 1.8 GHz frequency band signal and a 2.1 GHz frequency band signal share one base station. Therefore, a power amplifier in the base station needs to support both the signals in two frequency bands of 1.8 GHz and 2.1 GHz. A bandwidth between the two frequency bands (1805 MHz to 2170 MHz) is close to 400 MHz. An existing power amplifier design and an existing digital pre-distortion (digital pre-distortion, DPD) linear design cannot satisfy a requirement of a wireless communication protocol. A device circuit design of the power amplifier needs to be further optimized, and a video bandwidth (video bandwidth, VBW) needs to be increased, to improve a linear performance of DPD correction.

To better satisfy broadband performance, currently, for a power amplification device for a broadband application, an internal matching design is generally not used inside an output of the device, but a broadband external matching design is used in an external circuit of the device. However, in the external matching design, a high-power power amplification device has a large parasitic parameter and a small video bandwidth. This cannot satisfy a requirement of a large bandwidth and a requirement of a related protocol. In view of this, a new radio frequency power amplifier circuit needs to be provided, to increase the video bandwidth and improve linear performance of DPD correction when ensuring radio frequency performance of the power amplifier circuit.

**SUMMARY**

This application provides a power amplifier circuit and a radio frequency system, to increase a video bandwidth and improve linear performance of DPD correction when ensuring radio frequency performance of the power amplifier circuit.

According to a first aspect, this application provides a power amplifier circuit. The circuit includes: a power amplifier unit and a broadband improvement unit. The power amplifier unit includes: a signal input port, a signal output port, a power transistor, and a first inductor. A first end of the power transistor is grounded, a second end of the power transistor is connected to the signal input port, a third end of the power transistor is connected to a first end of the first inductor, and a second end of the first inductor is connected to the signal output port. The signal input port is configured to receive radio frequency signals in a plurality of frequency bands. The power transistor is configured to perform power amplification on the radio frequency signals in the plurality of frequency bands. The signal output port is configured to output the radio frequency signals that are in the plurality of frequency bands and on which power amplification is performed. The broadband improvement unit is configured to adjust a parallel resonance frequency of the power amplifier unit, to reduce envelope impedance of the power amplifier unit between a first target frequency and a second target frequency. The first target frequency is a maximum frequency difference between the plurality of frequency bands, and the second target frequency is a minimum frequency difference between the plurality of frequency bands.

In a possible implementation, the power amplifier unit further includes a chip package module. The first end of the power transistor is grounded through the chip package module, the second end of the power transistor is connected to the signal input port through the chip package module, the third end of the power transistor is connected to the first end of the first inductor, the second end of the first inductor is connected to the chip package module, and the first inductor is connected to the signal output port through the chip package module.

In a possible implementation, the broadband improvement unit includes: a decoupling capacitor, a radio frequency capacitor, a second inductor, a third inductor, and a first resistor. One end of the decoupling capacitor is grounded, the other end of the decoupling capacitor is connected to one end of the second inductor, the other end of the second inductor is connected to one end of the radio frequency capacitor, the other end of the radio frequency capacitor is grounded, the other end of the second inductor is further connected to one end of the first resistor, the other end of the first resistor is connected to one end of the third inductor, and the other end of the third inductor is connected to the second end of the first inductor.

According to the power amplifier circuit provided in this application, on the basis of not adding output internal matching circuit, the broadband improvement unit is connected inside or outside the chip package module of the power transistor, and the radio frequency capacitor, the second inductor, and the third inductor in the broadband improvement unit generate parallel resonance near an operating frequency band, to form high impedance. In this way, the broadband improvement unit is at high impedance when operating at a high frequency. The envelope impedance between the first target frequency and the second target frequency is reduced without affecting performance of the power amplifier unit at an operating frequency. The first resistor can suppress parasitic series resonance formed by the decoupling capacitor and the inductor, to form a smooth envelope impedance curve. Adding the broadband improvement unit can ensure radio frequency performance and reduce the envelope impedance, so that a video bandwidth of the power amplifier circuit is increased and DPD linearity of a broadband signal is improved.

In a possible implementation, the broadband improvement unit includes: a decoupling capacitor, a radio frequency capacitor, a second inductor, a third inductor, and a first resistor. One end of the decoupling capacitor is grounded, the other end of the decoupling capacitor is connected to one end of the second inductor, the other end of the second inductor is connected to one end of the first resistor, the other end of the first resistor is connected to one end of the radio frequency capacitor, the other end of the radio frequency capacitor is grounded, the other end of the first resistor is further connected to one end of the third inductor, and the other end of the third inductor is connected to the second end of the first inductor.

In connection manners of the foregoing two implementations, locations at which the first resistor and the radio frequency capacitor are connected are different, the broadband improvement unit is integrally connected to the second end of the first inductor, and the broadband improvement unit is connected outside the chip package module of the power transistor. Therefore, a difficulty in designing the circuit is reduced.

In a possible implementation, the broadband improvement unit includes: a decoupling capacitor, a radio frequency capacitor, a second inductor, a third inductor, and a first resistor. One end of the decoupling capacitor is grounded, the other end of the decoupling capacitor is connected to one end of the second inductor, the other end of the second inductor is connected to one end of the radio frequency capacitor, the other end of the radio frequency capacitor is grounded, the other end of the second inductor is further connected to one end of the first resistor, the other end of the first resistor is connected to one end of the third inductor, and the other end of the third inductor is connected to the first end of the first inductor.

In a possible implementation, the broadband improvement unit includes: a decoupling capacitor, a radio frequency capacitor, a second inductor, a third inductor, and a first resistor. One end of the decoupling capacitor is grounded, the other end of the decoupling capacitor is connected to one end of the second inductor, the other end of the second inductor is connected to one end of the first resistor, the other end of the first resistor is connected to one end of the radio frequency capacitor, the other end of the radio frequency capacitor is grounded, the other end of the first resistor is further connected to one end of the third inductor, and the other end of the third inductor is connected to the first end of the first inductor.

In connection manners of the foregoing two implementations, locations at which the first resistor and the radio frequency capacitor are connected are different, and the broadband improvement unit is integrally connected to the first end of the first inductor, in other words, the broadband improvement unit may be implemented inside the chip package module of the power transistor. Therefore, a circuit area of the entire power amplifier circuit is reduced. The foregoing design manners facilitate mass production of the power amplifier circuit.

In a possible implementation, the first inductor and/or the third inductor are/is disposed by using a wire bonding technology. The third inductor in the broadband improvement unit may be disposed by using the wire bonding technology. A value of the radio frequency capacitor is at a communication radio frequency pf level, and a value of the decoupling capacitor is at an nf level. The first resistor may be manufactured by using a thin film process, and the first resistor and the radio frequency capacitor may be located on one device, to reduce an area.

In a possible implementation, an envelope impedance peak of the power amplifier circuit is at the parallel resonance frequency, and the parallel resonance frequency of the power amplifier circuit satisfies the following formula:

$$Parallel\ resonance\ frequency = \frac{1}{2\pi\sqrt{(L_2 + L_3)(C_{ds} + C_f)}},$$

where

$L_2$ is an inductance value of the second inductor, $L_3$ is an inductance value of the third inductor, $C_{ds}$ is a capacitance value of a parasitic capacitor of the power transistor, and $C_f$ is a capacitance value of the radio frequency capacitor.

Between the first target frequency and the second target frequency, after the broadband improvement unit is added, the envelope impedance of the power amplifier unit is greatly reduced, so that a video bandwidth of the power amplifier circuit can be increased and a DPD linear performance can be improved.

In a possible implementation, the power amplifier circuit further includes a power supply. The power supply is configured to supply power to the power transistor.

According to a second aspect, this application provides a radio frequency system. The system includes a power supply, a radio frequency antenna, and the power amplifier circuit provided in the first aspect. The power supply is configured to supply power to the power amplifier circuit. The radio frequency antenna is configured to send radio frequency signals that are in a plurality of frequency bands and on which power amplification is performed.

These aspects or another aspect of this application is clearer and more comprehensible in descriptions of the following embodiments.

## BRIEF DESCRIPTION OF DRAWINGS

FIG. 1 is a diagram of a structure of a power amplifier circuit in a conventional technology;
FIG. 2 is a diagram of a structure of another power amplifier circuit in a conventional technology;
FIG. 3 is a diagram of a structure of a power amplifier circuit according to this application;
FIG. 4 is a first diagram of a structure of a power amplifier unit according to this application;
FIG. 5 is a second diagram of a structure of a power amplifier unit according to this application;
FIG. 6A is a first diagram of a specific structure of a power amplifier circuit according to this application;
FIG. 6B is a second diagram of a specific structure of a power amplifier circuit according to this application;
FIG. 7 is a first curve chart of envelope impedance changing with a frequency according to this application;
FIG. 8A is a third diagram of a specific structure of a power amplifier circuit according to this application;
FIG. 8B is a fourth diagram of a specific structure of a power amplifier circuit according to this application; and
FIG. 9 is a second curve chart of envelope impedance changing with a frequency according to this application.

## DESCRIPTION OF EMBODIMENTS

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in descriptions of this application, "at least one" means one or more, and "a plurality of" means two or more. In view of this, in embodiments of the present invention, "a plurality of" may also be understood as "at least two". The term "and/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects unless otherwise specified. In addition, it should be understood that in the descriptions of this application, the terms such as "first" and "second" are merely used for distinguishing and description, but should not be understood as indicating or implying relative importance, or should not be understood as indicating or implying a sequence.

It should be noted that, in embodiments of this application, "connection" means an electrical connection, and a connection between two electrical elements may be a direct or indirect connection between the two electrical elements. For example, a connection between A and B may be a direct connection between A and B, or may be an indirect connection between A and B through one or more other electrical elements. For example, that A is connected to B may also be that A is directly connected to C, C is directly connected to B, A and B are connected through C.

In addition, in this application, unless otherwise explicitly specified and defined, the terms such as "connect", "connection", and "dispose" should be understood in a broad sense. For example, the connection may be a fixed connection, a detachable connection, or an integral connection; or the connection may be a mechanical connection or an electrical connection; or the connection may be a direct connection, an indirect connection through an intermediate medium, or internal communication between two components or a mutual interaction relationship between two components. A person of ordinary skill in the art may understand specific meanings of the terms in the present invention based on specific situations.

With the update of wireless technologies, a data transmission capability is significantly improved, and a signal bandwidth is also expanded accordingly. To satisfy an increasing user data requirement, expanding the signal bandwidth is the most effective method. However, the shortage of spectrums and the effective utilization of base station resources encourage more operators to share base station resources and the spectrums. In this way, a base station needs to support a large signal bandwidth. For example, a 1.8 GHz frequency band signal and a 2.1 GHz frequency band signal share one base station. Therefore, a power amplifier circuit in the base station needs to support performing power amplification on both the signals in two frequency bands (1.8 GHz and 2.1 GHz). However, a bandwidth between the frequency bands (1805 MHz to 2170 MHz) is close to 400 MHz. Therefore, the power amplifier circuit needs to be designed for a wide bandwidth.

To enable a person skilled in the art to better understand the technical solutions in embodiments of this application, a conventional technology is first described.

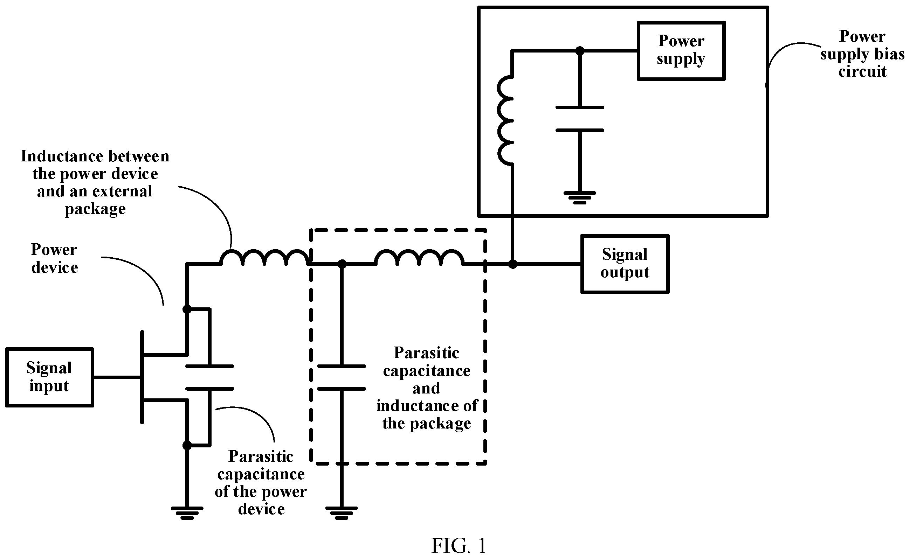

To better satisfy broadband performance of the power amplifier circuit, internal matching is generally not used inside an output of the power amplifier circuit, but a broadband external matching design is used in an external circuit of the power amplifier circuit, as shown in a structure of a power amplifier circuit in the conventional technology in FIG. 1. To increase a video bandwidth of the power amplifier circuit, at least one of the following methods may be used: reducing parasitic capacitance inside a power amplification device, reducing inductance between the power amplification device and an external package, and reducing parasitic capacitance and parasitic inductance of the external package. Optionally, a power supply bias circuit may be added outside the power amplifier circuit to increase the video bandwidth of the power amplifier circuit. Refer to FIG. 1. When the parasitic capacitance inside the power amplification device, the inductance between the power amplification device and the external package, the parasitic capacitance and the parasitic inductance of the external package are all fixed values, the video bandwidth of the power amplifier circuit is increased by adjusting inductance from a power supply end to a signal output end on the power supply bias circuit. To avoid affecting impedance and radio frequency performance of the power amplifier circuit, the inductance from the power supply end to the signal output end on the power supply bias circuit is generally large. The inductance between the power amplification device and the external package and the parasitic inductance of the external package are smaller than the inductance from the power supply end to the signal output end on the power supply bias circuit. Therefore, a resonance frequency corresponding to an envelope impedance peak of the power amplifier circuit to which the power supply bias circuit is added may be determined by the inductance from the power supply end to the signal output end on the power supply bias circuit. However, because the inductance from the power supply end to the signal output end on the power supply bias circuit is generally large, an optimization effect of the video bandwidth is limited, and a current requirement for increasing the video bandwidth cannot be satisfied.

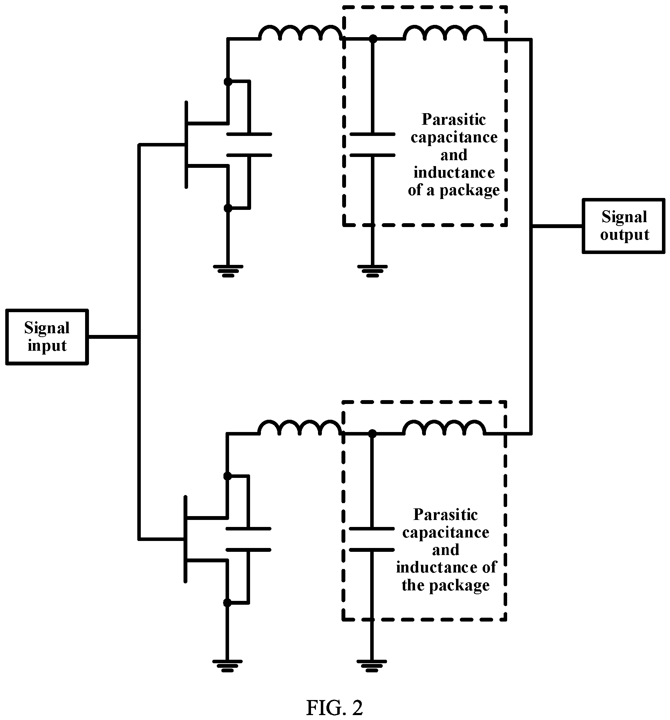

FIG. 2 is a diagram of a structure of another power amplifier circuit in a conventional technology. As shown in FIG. 2, a plurality of low-power power amplification devices are combined into a high-power power amplification device in a peripheral combination manner for use, to ensure that a current requirement for increasing a video bandwidth is satisfied. However, when the plurality of low-power power amplification devices are combined into the high-power power amplification device, a layout area of the plurality of low-power power amplification devices is large, and there is a problem of a combination loss in a process of combining the plurality of low-power power amplification devices. Therefore, under the trend of low costs and miniaturization of modules, the power amplifier circuit of this structure is gradually being phased out.

For the foregoing problem in the conventional technology, this application provides a power amplifier circuit. A newly added broadband improvement unit is used to increase a video bandwidth and improve linear performance of DPD correction when ensuring radio frequency performance of the power amplifier circuit.

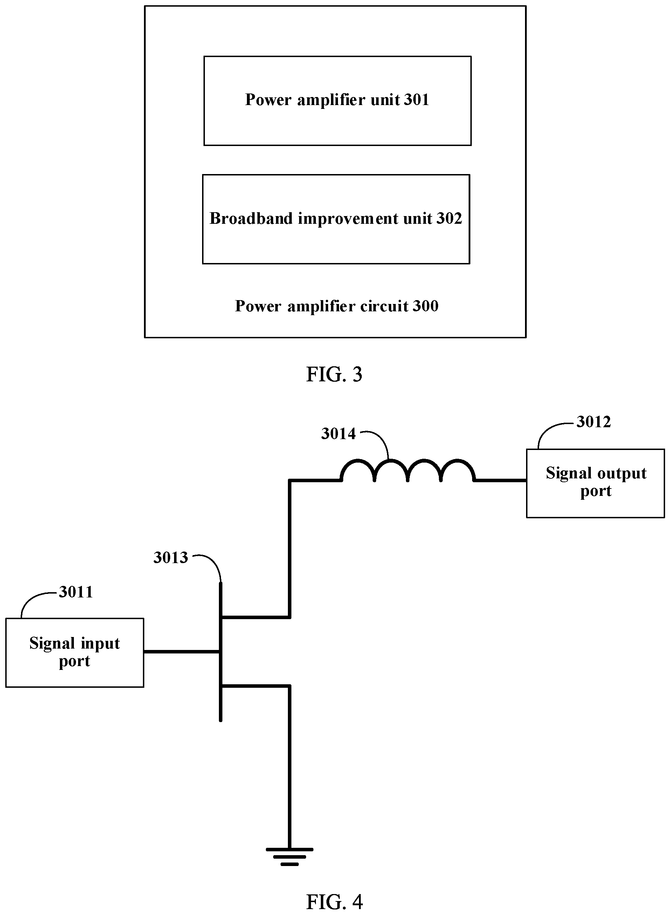

FIG. 3 is a diagram of a structure of a power amplifier circuit according to an embodiment of this application. The power amplifier circuit 300 provided in this embodiment includes: a power amplifier unit 301 and a broadband improvement unit 302.

The power amplifier unit 301 is configured to perform power amplification on radio frequency signals in a plurality of frequency bands. The radio frequency signal is a high-frequency electromagnetic wave having a long-distance transmission capability.

The broadband improvement unit 302 is configured to adjust a parallel resonance frequency of the power amplifier unit 301, to reduce envelope impedance of the power amplifier unit 301 between a first target frequency and a second target frequency. The first target frequency is a maximum frequency difference between the plurality of frequency bands, and the second target frequency is a minimum frequency difference between the plurality of frequency bands.

It should be noted that the plurality of frequency bands may include at least two frequency bands. For example, the plurality of frequency bands include two frequency band signals. If a frequency band signal (in 1805 MHz to 1880 MHz) and a frequency band signal (in 2110 MHz to 2170 MHz) share one base station, the first target frequency is 365 MHz (2170 MHz-1805 MHz), and the second target frequency is 230 MHz (2110 MHz-1880 MHz).

The power amplifier circuit 300 provided in this embodiment of this application may be used in a radio frequency power component integrated into a wireless communication device such as a base station, for example, a radio frequency processing device or circuit that performs radio signal power amplification, for example, a radio frequency filter, an antenna, a radio frequency small signal board, a repeater, a frequency conversion circuit, or a modulator. In a mobile communication system, to-be-transmitted user data is modulated to a radio frequency signal at a radio frequency front end of a base station or a user terminal, and the radio frequency signal is amplified through the power amplifier circuit in this application and then transmitted to another base station or user terminal in space via an antenna.

The power amplifier unit 301 may include a power amplification device configured to perform power amplification and a controller. The power amplification device may be one or more of a plurality of types of switch devices such as a metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), a field-effect transistor (field-effect transistor, FET), a laterally-diffused metal-oxide semiconductor (laterally-diffused metal-oxide semiconductor, LDMOS), silicon carbide (SiC), gallium nitride (GaN), and gallium arsenide (GaAs), which are not listed one by one in embodiments of this application. The foregoing power amplification devices may each include a first electrode (source), a second electrode (drain), and a control electrode (gate). The controller controls connection or disconnection of the power amplification device through the control electrode, to complete power amplification on the radio frequency signal. Because a parasitic parameter of the power amplification device is large, a video bandwidth is small.

The envelope impedance (or referred to as baseband impedance) of the power amplifier unit 301 directly affects indicators such as linearity, power, and efficiency during amplification of the radio frequency signal. Therefore, under a same condition, as the envelope impedance of the power amplifier unit 301 increases, output power, efficiency, and a gain of the power amplifier unit 301 decrease to a specific extent. Therefore, to enable the power amplifier unit 301 in the base station to support a larger signal bandwidth, the envelope impedance of the power amplifier unit 301 between the first target frequency and the second target frequency needs to be reduced, to increase a video bandwidth of the power amplifier unit 301 when ensuring radio frequency performance of the power amplifier unit 301.

In a possible implementation, refer to FIG. 4. The power amplifier unit 301 includes: a signal input port 3011, a signal output port 3012, a power transistor 3013, and a first inductor 3014. The following describes connection relationships between the devices in the power amplifier unit 301 with reference to FIG. 4.

A first end of the power transistor 3013 is grounded, a second end of the power transistor 3013 is connected to the signal input port 3011, a third end of the power transistor 3013 is connected to a first end of the first inductor 3014, and a second end of the first inductor 3014 is connected to the signal output port 3012.

The signal input port 3011 is configured to receive radio frequency signals in a plurality of frequency bands. The power transistor 3013 is configured to perform power amplification on the radio frequency signals in the plurality of frequency bands. The signal output port 3012 is configured to output the radio frequency signals that are in the plurality of frequency bands and on which power amplification is performed.

The first inductor 3014 in the power amplifier unit 301 may be connected between the power transistor 3013 and the signal output port 3012 by using a wire bonding technology (a metal bonding line) or a short microstrip. The signal input port 3011, the signal output port 3012, the power transistor 3013, and the first inductor 3014 in the power amplifier unit 301 may be disposed on a same substrate, and a transmission line and a radio frequency ground are disposed on the substrate.

In a possible implementation, the power amplifier circuit 300 further includes: an input matching circuit and an output matching circuit. The input matching circuit is configured to match first impedance of the signal input port 3011 as second impedance input by the power transistor 3013. The output matching circuit is configured to match third impedance output by the power transistor 3013 as fourth impedance of the signal output port. The signal input port may be connected to the power transistor 3013 through the input matching circuit. The power transistor 3013 is connected to the signal output port 3012 through the output matching circuit.

In a possible implementation, the power amplifier unit 301 further includes a power supply. The power supply is configured to supply power to the power transistor 3013.

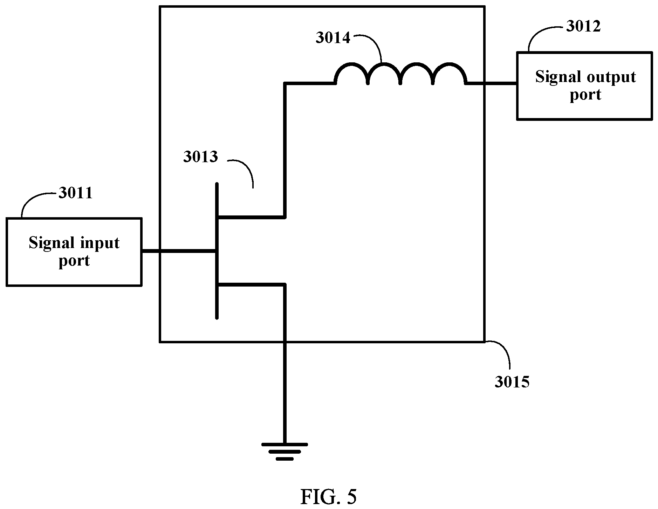

In a possible implementation, refer to FIG. 5. The power amplifier unit 301 further includes a chip package module 3015. The first end of the power transistor 3013 is grounded through the chip package module 3015, the second end of the power transistor 3013 is connected to the signal input port through the chip package module 3015, the third end of the power transistor 3013 is connected to the first end of the first inductor 3014, the second end of the first inductor 3014 is connected to the chip package module 3015, and the first inductor 3014 is connected to the signal output port 3012 through the chip package module 3015. The first inductor 3014 in the power amplifier unit 301 may be connected between the power transistor 3013 and the chip package module 3015 by using the wire bonding technology.

The broadband improvement unit 302 may include a resistor, an inductor, and a capacitor. The capacitor and the inductor in the broadband improvement unit 302 may generate parallel resonance at an operating frequency of the power amplifier unit 301, so that the broadband improvement unit 302 is at high impedance, and the radio frequency performance of the power amplifier unit 301 is not affected. In addition, the resistor in the broadband improvement unit 302 can suppress parasitic series impedance formed by the capacitor and the inductor, to form a smooth envelope impedance curve.

The broadband improvement unit 302 has a plurality of different structures, and the broadband improvement unit 302 may be connected to the power amplifier unit 301. All the structures can achieve a function of increasing the video bandwidth and improving linear performance of DPD correction when ensuring the radio frequency performance of the power amplifier unit 301.

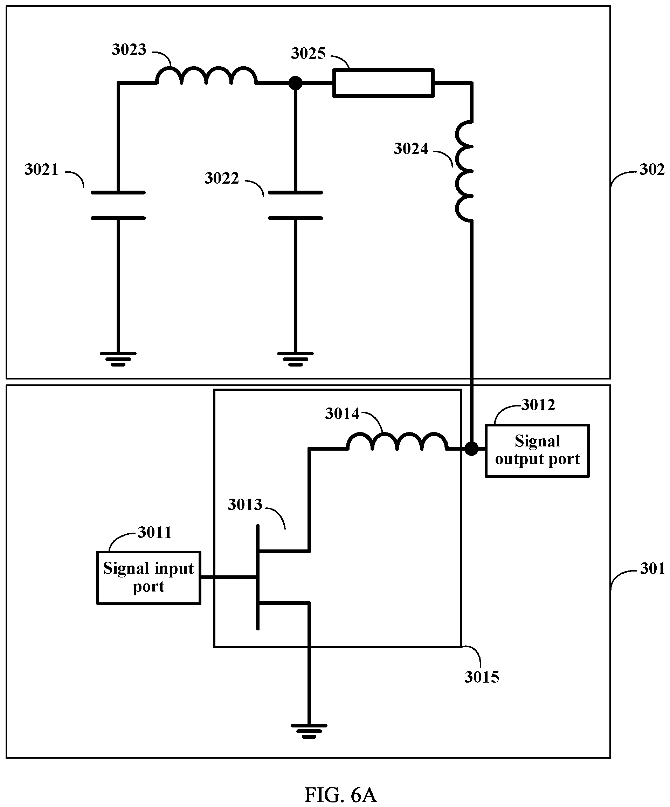

Structure 1: Refer to FIG. 6A. The broadband improvement unit 302 may include: a decoupling capacitor 3021, a radio frequency capacitor 3022, a second inductor 3023, a third inductor 3024, and a first resistor 3025. One end of the decoupling capacitor 3021 is grounded, the other end of the decoupling capacitor 3021 is connected to one end of the second inductor 3023, the other end of the second inductor 3023 is connected to one end of the radio frequency capacitor 3022, the other end of the radio frequency capacitor 3022 is grounded, the other end of the second inductor 3023 is further connected to one end of the first resistor 3025, the other end of the first resistor 3025 is connected to one end of the third inductor 3024, and the other end of the third inductor 3024 is connected to the second end of the first inductor 3014.

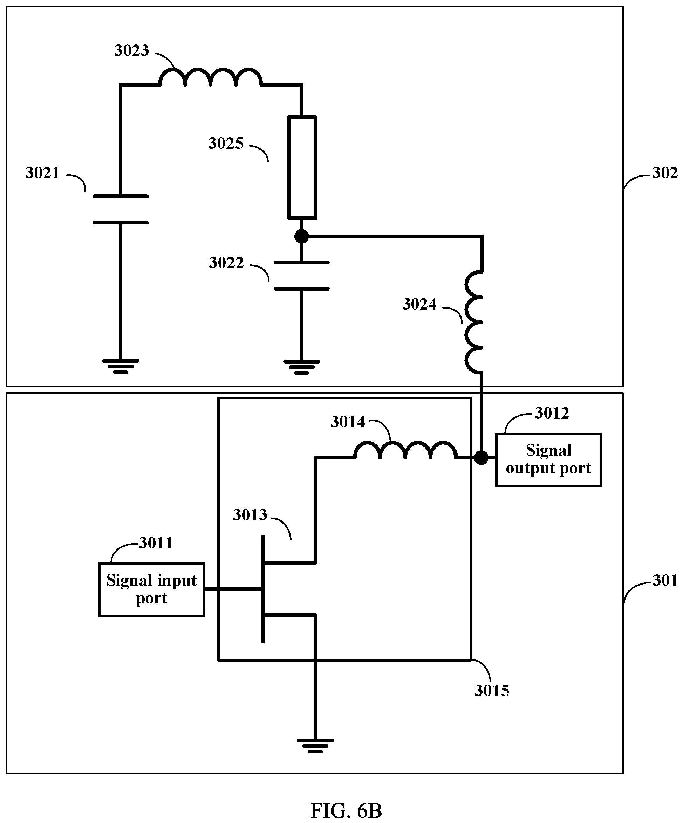

Structure 2: Refer to FIG. 6B. The broadband improvement unit 302 may include: a decoupling capacitor 3021, a radio frequency capacitor 3022, a second inductor 3023, a third inductor 3024, and a first resistor 3025. One end of the decoupling capacitor 3021 is grounded, the other end of the decoupling capacitor 3021 is connected to one end of the second inductor 3023, the other end of the second inductor 3023 is connected to one end of the first resistor 3025, the other end of the first resistor 3025 is connected to one end of the radio frequency capacitor 3022, the other end of the radio frequency capacitor 3022 is grounded, the other end of the first resistor 3025 is further connected to one end of the third inductor 3024, and the other end of the third inductor 3024 is connected to the second end of the first inductor 3014.

A difference between the structure 1 and the structure 2 is that locations at which the first resistor 3025 and the radio frequency capacitor 3022 are connected are different. A common point between the structure 1 and the structure 2 is that the broadband improvement unit 302 is integrally connected to the second end of the first inductor 3014. In other words, this may represent that the broadband improvement unit 302 is connected outside the chip package module 3015 of the power transistor 3013. Therefore, a difficulty in designing the circuit is reduced.

At an output pin of the power transistor 3013, a curve chart of the envelope impedance changing with a frequency may be obtained through testing. An envelope impedance peak of the power amplifier circuit 300 is at the parallel resonance frequency. The parallel resonance frequency of the power amplifier circuit 300 satisfies the following formula:

$$Parallel\ resonance\ frequency = \frac{1}{2\pi\sqrt{(L_2 + L_3)(C_{ds} + C_f)}},$$

where

$L_2$ is an inductance value of the second inductor, $L_3$ is an inductance value of the third inductor, $C_{ds}$ is a capacitance value of a parasitic capacitor of the power transistor, and $C_f$ is a capacitance value of the radio frequency capacitor.

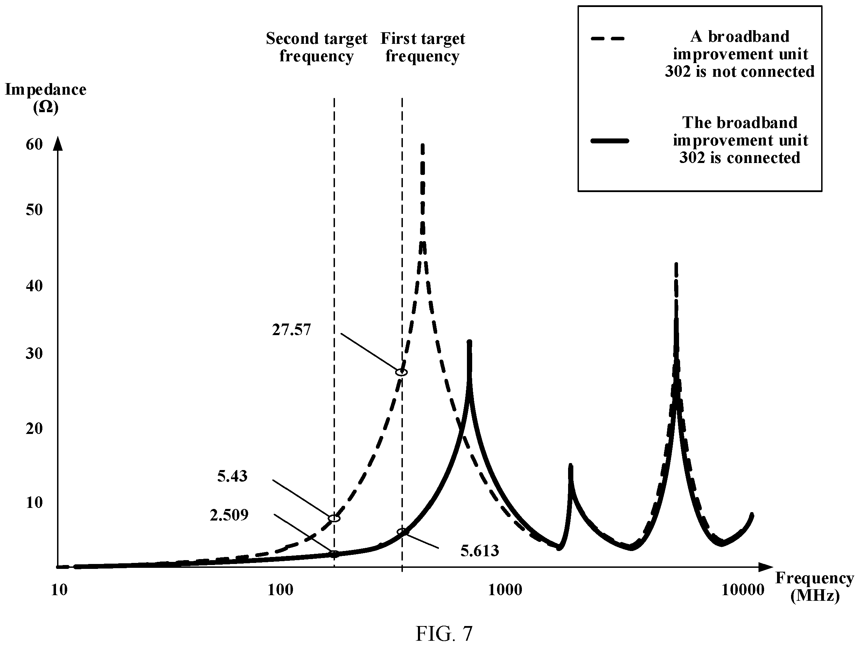

FIG. 7 is a curve chart of the envelope impedance. In FIG. 7, a dashed line indicates an envelope impedance test result obtained when the broadband improvement unit 302 is not connected originally, and a solid line indicates an envelope impedance test result obtained after the broadband improvement unit 302 is connected.

An example in which the first target frequency is 400 MHz and the second target frequency is 200 MHz is used. It can be learned from FIG. 7 that, between the first target frequency and the second target frequency, the envelope impedance is greatly reduced after the broadband improvement unit 302 is connected, so that the video bandwidth of the power amplifier circuit 300 can be increased and a DPD linear performance can be improved.

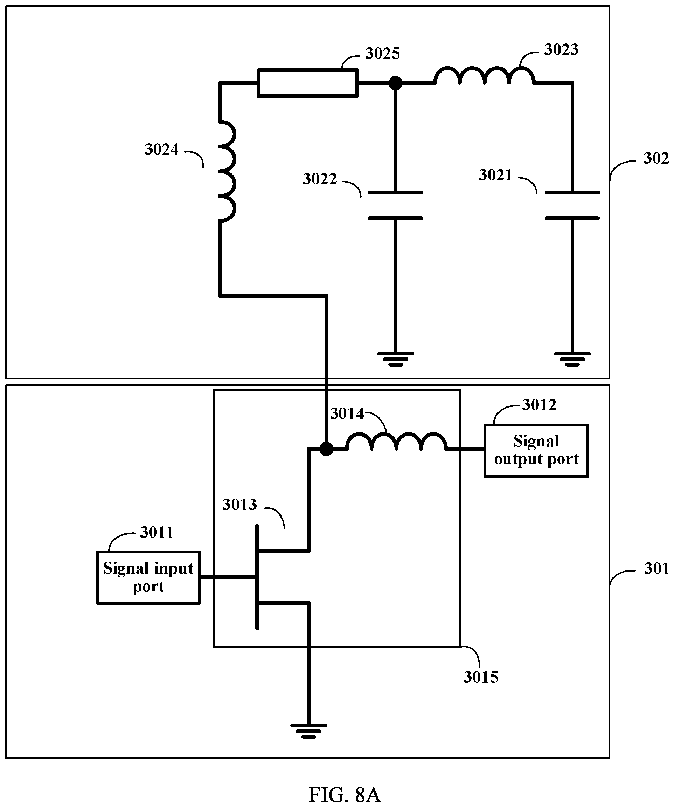

Structure 3: Refer to FIG. 8A. The broadband improvement unit 302 may include: a decoupling capacitor 3021, a radio frequency capacitor 3022, a second inductor 3023, a third inductor 3024, and a first resistor 3025. One end of the decoupling capacitor 3021 is grounded, the other end of the decoupling capacitor 3021 is connected to one end of the second inductor 3023, the other end of the second inductor 3023 is connected to one end of the radio frequency capacitor 3022, the other end of the radio frequency capacitor 3022 is grounded, the other end of the second inductor 3023 is further connected to one end of the first resistor 3025, the other end of the first resistor 3025 is connected to one end of the third inductor 3024, and the other end of the third inductor 3024 is connected to the first end of the first inductor 3014.

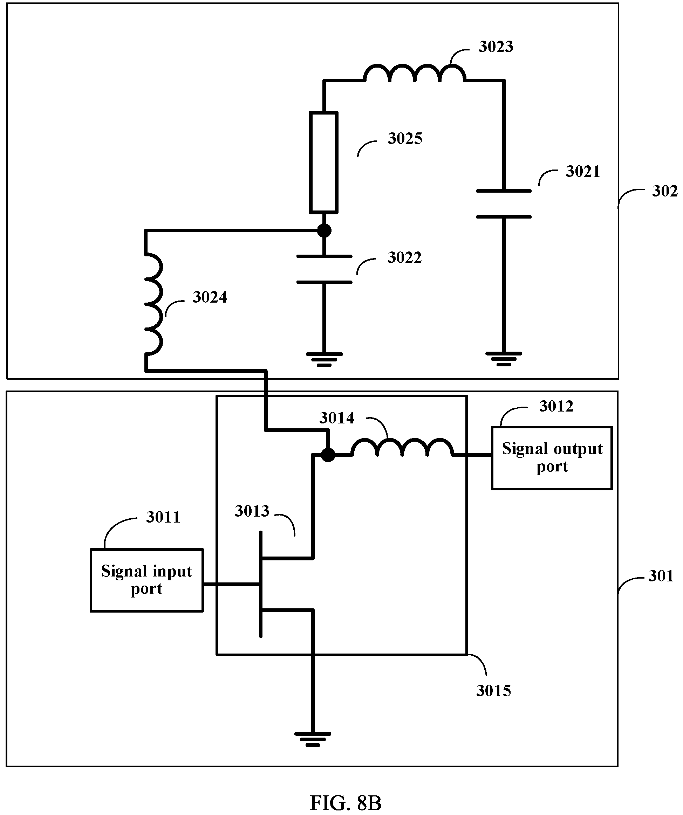

Structure 4: Refer to FIG. 8B. The broadband improvement unit 302 may include: a decoupling capacitor 3021, a radio frequency capacitor 3022, a second inductor 3023, a third inductor 3024, and a first resistor 3025. One end of the decoupling capacitor 3021 is grounded, the other end of the decoupling capacitor 3021 is connected to one end of the second inductor 3023, the other end of the second inductor 3023 is connected to one end of the first resistor 3025, the other end of the first resistor 3025 is connected to one end of the radio frequency capacitor 3022, the other end of the radio frequency capacitor 3022 is grounded, the other end of the first resistor 3025 is further connected to one end of the third inductor 3024, and the other end of the third inductor 3024 is connected to the first end of the first inductor 3014.

A difference between the structure 3 and the structure 4 is that locations at which the first resistor 3025 and the radio frequency capacitor 3022 are connected are different. A common point between the structure 1 and the structure 2 is that the broadband improvement unit 302 is integrally connected to the first end of the first inductor 3014. This may represent that the broadband improvement unit 302 is connected inside the chip package module 3015 of the power transistor 3013. In other words, the broadband improvement unit 302 may be implemented inside a power transistor 3013 package. Therefore, a circuit area of the entire power amplifier circuit 300 is reduced. The foregoing design manners facilitate mass production of the power amplifier circuit 300.

At an output pin of the power transistor 3013, a curve chart of the envelope impedance changing with a frequency may be obtained through testing. An envelope impedance peak of the power amplifier circuit 300 is at the parallel resonance frequency. The parallel resonance frequency of the power amplifier circuit 300 satisfies the following formula:

$$Parallel\ resonance\ frequency = \frac{1}{2\pi\sqrt{\left(L_2 + L_3\right)\left(C_{ds} + C_f\right)}},$$

where
$L_2$ is an inductance value of the second inductor, $L_3$ is an inductance value of the third inductor, $C_{ds}$ is a capacitance value of a parasitic capacitor of the power transistor, and $C_f$ is a capacitance value of the radio frequency capacitor.

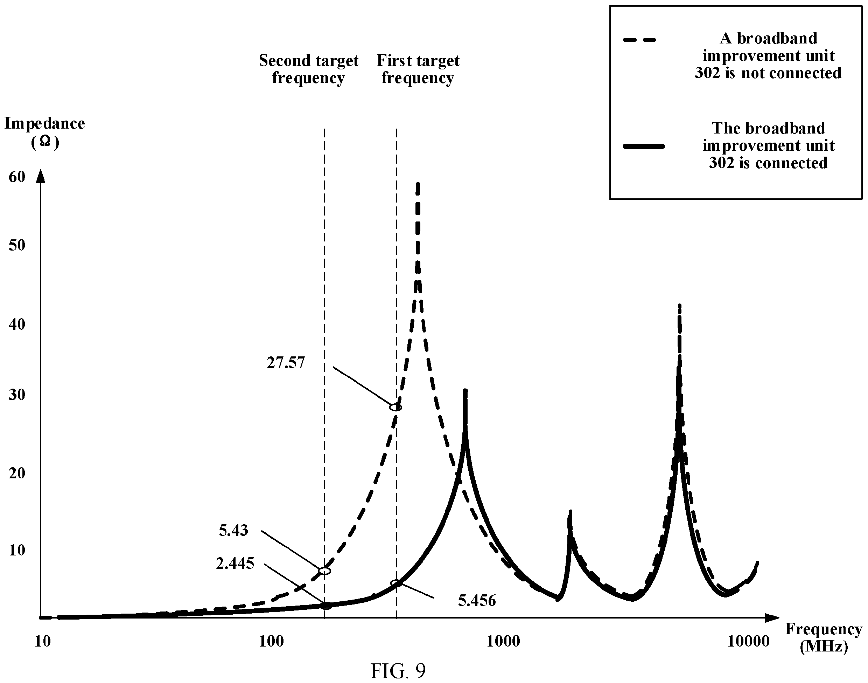

FIG. 9 is another curve chart of the envelope impedance. In FIG. 9, a dashed line indicates an envelope impedance test result obtained when the broadband improvement unit 302 is not connected originally, and a solid line indicates an envelope impedance test result obtained after the broadband improvement unit 302 is connected.

An example in which the first target frequency is 400 MHz and the second target frequency is 200 MHz is still used. It can be learned from FIG. 9 that, between the first target frequency and the second target frequency, the envelope impedance is also greatly reduced after the broadband improvement unit 302 is connected, so that the video bandwidth of the power amplifier circuit 300 can be increased and a DPD linear performance can be improved.

The third inductor 3024 in the broadband improvement unit 302 may also be disposed by using the wire bonding technology (the metal bonding line) or the short microstrip. A value of the radio frequency capacitor 3022 is at a communication radio frequency pf level, and a value of the decoupling capacitor is at an nf level. The first resistor 3025 may be manufactured by using a thin film process, and the first resistor 3025 and the radio frequency capacitor 3022 may be located on one device, to reduce an area.

In the power amplifier circuit provided in this embodiment of this application, on the basis of not adding output internal matching circuit, the broadband improvement unit is connected inside or outside the chip package module of the power transistor. The radio frequency capacitor, the second inductor, and the third inductor in the broadband improvement unit generate parallel resonance near an operating frequency band, to form high impedance. In this way, the broadband improvement unit is at high impedance when operating at a high frequency. Therefore, the envelope impedance between the first target frequency and the second target frequency is reduced without affecting performance of the power amplifier unit at an operating frequency. The first resistor can suppress parasitic series resonance formed by the decoupling capacitor and the inductor, to form a smooth envelope impedance curve. Adding the broadband improvement unit can ensure the radio frequency performance and reduce the envelope impedance, so that the video bandwidth of the power amplifier circuit is increased and DPD linearity of a broadband signal is improved.

Based on the same concept, this application further provides a radio frequency system. The system includes a power supply, a radio frequency antenna, and the power amplifier circuit 300 described in the foregoing embodiment. The power supply is configured to supply power to the power amplifier circuit 300. The radio frequency antenna is configured to send radio frequency signals that are in a plurality of frequency bands and on which power amplification is performed.

Although embodiments of this application have been described, a person skilled in the art can make other changes and modifications to these embodiments once the basic inventive concept is learned. Therefore, the following claims are intended to be construed as to cover the preferred embodiments and all changes and modifications falling within the scope of this application.

It is clear that a person skilled in the art can make various modifications and variations to embodiments of this application without departing from the scope of embodiments of this application. In this case, this application is intended to cover these modifications and variations of embodiments of this application provided that they fall within the scope of protection defined by the following claims and their equivalent technologies.

## Claims

1. A power amplifier circuit, wherein the circuit comprises: a power amplifier unit and a broadband improvement unit;

   the power amplifier unit comprises: a signal input port, a signal output port, a power transistor, and a first inductor; a first end of the power transistor is grounded, a second end of the power transistor is connected to the signal input port, a third end of the power transistor is connected to a first end of the first inductor, and a second end of the first inductor is connected to the signal output port;
   the signal input port is configured to receive radio frequency signals in a plurality of frequency bands; the power transistor is configured to perform power amplification on the radio frequency signals in the plurality of frequency bands; the signal output port is configured to output the radio frequency signals that are in the plurality of frequency bands and on which power amplification is performed; and

the broadband improvement unit is configured to adjust a parallel resonance frequency of the power amplifier unit, to reduce envelope impedance of the power amplifier unit between a first target frequency and a second target frequency, wherein the first target frequency is a maximum frequency difference between the plurality of frequency bands, and the second target frequency is a minimum frequency difference between the plurality of frequency bands.

2. The circuit according to claim 1, wherein the broadband improvement unit comprises: a decoupling capacitor, a radio frequency capacitor, a second inductor, a third inductor, and a first resistor;

one end of the decoupling capacitor is grounded, the other end of the decoupling capacitor is connected to one end of the second inductor, the other end of the second inductor is connected to one end of the radio frequency capacitor, the other end of the radio frequency capacitor is grounded, the other end of the second inductor is further connected to one end of the first resistor, the other end of the first resistor is connected to one end of the third inductor, and the other end of the third inductor is connected to the second end of the first inductor.

3. The circuit according to claim 1, wherein the broadband improvement unit comprises: a decoupling capacitor, a radio frequency capacitor, a second inductor, a third inductor, and a first resistor;

one end of the decoupling capacitor is grounded, the other end of the decoupling capacitor is connected to one end of the second inductor, the other end of the second inductor is connected to one end of the first resistor, the other end of the first resistor is connected to one end of the radio frequency capacitor, the other end of the radio frequency capacitor is grounded, the other end of the first resistor is further connected to one end of the third inductor, and the other end of the third inductor is connected to the second end of the first inductor.

4. The circuit according to claim 1, wherein the broadband improvement unit comprises: a decoupling capacitor, a radio frequency capacitor, a second inductor, a third inductor, and a first resistor;

one end of the decoupling capacitor is grounded, the other end of the decoupling capacitor is connected to one end of the second inductor, the other end of the second inductor is connected to one end of the radio frequency capacitor, the other end of the radio frequency capacitor is grounded, the other end of the second inductor is further connected to one end of the first resistor, the other end of the first resistor is connected to one end of the third inductor, and the other end of the third inductor is connected to the first end of the first inductor.

5. The circuit according to claim 1, wherein the broadband improvement unit comprises: a decoupling capacitor, a radio frequency capacitor, a second inductor, a third inductor, and a first resistor;

one end of the decoupling capacitor is grounded, the other end of the decoupling capacitor is connected to one end of the second inductor, the other end of the second inductor is connected to one end of the first resistor, the other end of the first resistor is connected to one end of the radio frequency capacitor, the other end of the radio frequency capacitor is grounded, the other end of the first resistor is further connected to one end of the third inductor, and the other end of the third inductor is connected to the first end of the first inductor.

6. The circuit according to any one of claims 1 to 5, wherein the power amplifier unit further comprises a chip package module; and

the first end of the power transistor is grounded through the chip package module, the second end of the power transistor is connected to the signal input port through the chip package module, the third end of the power transistor is connected to the first end of the first inductor, the second end of the first inductor is connected to the chip package module, and the first inductor is connected to the signal output port through the chip package module.

7. The circuit according to any one of claims 2 to 6, wherein the first inductor and/or the third inductor are/is disposed by using a wire bonding technology.

8. The circuit according to any one of claims 1 to 7, wherein an envelope impedance peak of the power amplifier circuit is at the parallel resonance frequency, and the parallel resonance frequency of the power amplifier circuit satisfies the following formula:

$$Parallel\ resonance\ frequency = \frac{1}{2\pi\sqrt{(L_2 + L_3)(C_{ds} + C_f)}},$$

wherein

$L_2$ is an inductance value of the second inductor, $L_3$ is an inductance value of the third inductor, $C_{ds}$ is a capacitance value of a parasitic capacitor of the power transistor, and $C_f$ is a capacitance value of the radio frequency capacitor.

9. The circuit according to any one of claims 1 to 8, wherein the power amplifier circuit further comprises a power supply; and the power supply is configured to supply power to the power transistor.

10. A radio frequency system, wherein the system comprises a power supply, a radio frequency antenna, and the power amplifier circuit according to any one of claims 1 to 9;

the power supply is configured to supply power to the power amplifier circuit; and

the radio frequency antenna is configured to transmit a radio frequency signal which is amplified by the power amplifier circuit.

Power
supply bias
circuit

Power
supply

Inductance between
the power device
and an external
package

Power
device

Signal
output

Signal
input

Parasitic
capacitance
and
inductance of
the package

Parasitic
capacitance
of the power
device

FIG. 1

FIG. 2

Power amplifier unit 301

Broadband improvement unit 302

Power amplifier circuit 300

FIG. 3

FIG. 4

FIG. 5

FIG. 6A

3023

3025

3021

302

3022

3024

3014

3012

**Signal output port**

3013

3011

**Signal input port**

301

3015

FIG. 6B

FIG. 7

FIG. 8A

FIG. 8B

FIG. 9

## INTERNATIONAL SEARCH REPORT

| | International application No. |
|---|---|
| | **PCT/CN2022/091778** |

**A. CLASSIFICATION OF SUBJECT MATTER**

H03F 3/189(2006.01)i

According to International Patent Classification (IPC) or to both national classification and IPC

**B. FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 射频, RF, 功率放大, 包络阻抗, 并联谐振频率, 带宽 or 宽带, 提升 or 增大 or 增加, radio w frequency, power w amplif+, envelope w impedance+, resonant w frequency, bandwidth, increas+

**C. DOCUMENTS CONSIDERED TO BE RELEVANT**

| Category* | Citation of document, with indication, where appropriate, of the relevant passages | Relevant to claim No. |
|---|---|---|
| X | CN 107070417 A (FREESCALE SEMICONDUCTOR INC.) 18 August 2017 (2017-08-18) description, paragraphs [0052]-[0150], and figures 1-13 | 1-10 |
| A | CN 111654249 A (CHONGQING UNIVERSITY) 11 September 2020 (2020-09-11) entire document | 1-10 |
| A | CN 203590161 U (GUANGZHOU JUNHENG MICROELECTRONICS TECHNOLOGY CO., LTD.) 07 May 2014 (2014-05-07) entire document | 1-10 |
| A | JP 2008219327 A (SHARP K. K.) 18 September 2008 (2008-09-18) entire document | 1-10 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 December 2022** | **19 December 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/091778**

| Patent document cited in search report | | | Publication date (day/month/year) | Patent family member(s) | | | Publication date (day/month/year) |
|---|---|---|---|---|---|---|---|
| CN | 107070417 | A | 18 August 2017 | US | 2017117856 | A1 | 27 April 2017 |
| | | | | EP | 3160042 | A1 | 26 April 2017 |
| CN | 111654249 | A | 11 September 2020 | None | | | |
| CN | 203590161 | U | 07 May 2014 | None | | | |
| JP | 2008219327 | A | 18 September 2008 | None | | | |

Form PCT/ISA/210 (patent family annex) (January 2015)